# EUROPEAN PATENT SPECIFICATION

(11) **EP 3 506 348 B1**
(45) Date of publication and mention of the grant of the patent: **24.11.2021**
(21) Application number: 18209021.7
(22) Date of filing: 28.11.2018
(51) Int. Cl.: H01L 23/498, H01L 23/50, H01L 21/48

(54) **THIN FILM PASSIVE DEVICES INTEGRATED IN A PACKAGE SUBSTRATE**
IN EIN GEHÄUSESUBSTRAT INTEGRIERTE PASSIVE DÜNNSCHICHTVORRICHTUNGEN
DISPOSITIFS PASSIFS À COUCHE MINCE INTÉGRÉS DANS UN SUBSTRAT D'EMBALLAGE

(30) Priority: 28.12.2017 US 201715857454
(43) Date of publication of application: 03.07.2019
(73) Proprietor: INTEL Corporation, Santa Clara, CA 95054 (US)
(72) Inventor: ALEKSOV, Aleksandar, Chandler, AZ Arizona 85286 (US); DARMAWIKARTA, Kristof, Chandler, AZ Arizona 85249 (US); GAAN, Sandeep, Chandler, AZ 85226 (US); PIETAMBARAM, Srinivas V., Gilbert, AZ Arizona 85297 (US); PAITAL, Sameer R., Chandler, AZ Arizona 85225 (US)
(74) Representative: Müller, Stefan

(56) References cited:
- US-A1- 2006 245 139
- US-A1- 2016 088 736
- US-A1- 2017 040 211

## Description

### BACKGROUND

Computing platforms, such as smart phones or tablets, for example, may include many discrete resistors and capacitors as part of input/output signals, power delivery, or other circuits. Conventionally these discrete components are manufactured using silicon technology and subsequently packaged and assembled as one or more discrete components on a motherboard or integrated circuit package, for example. This approach requires expensive silicon based manufacturing, adds significant z-height to the package or board, and requires assembly of the discrete components. Therefore, there is a need for package integrated discrete components that address these issues. For example US 2016/0088736 A1 describes the integration of embedded thin film capacitors in package substrates. Furthermore US 2006/0245139 describes a package substrate with a built-in capacitor and a manufacturing method thereof.

### Summary

A package substrate according to claim 1, a system according to claim 6, a method of manufacturing a package substrate according to claim 7 and an apparatus produced from the method of claim 7 are presented.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
**Fig. 1** illustrates an example circuit that may be implemented with thin film passive devices integrated in a package substrate, according to some embodiments,
**Figs. 2A-2H** illustrate cross-sectional views of manufacturing steps of thin film passive devices integrated in a package substrate, according to some embodiments,
**Figs. 3A-3F** illustrate cross-sectional views of manufacturing steps of thin film passive devices integrated in a package substrate, according to some embodiments,
**Fig. 4** illustrates a cross-sectional view of an example system with thin film passive devices integrated in a package substrate, according to some embodiments,
**Fig. 5** illustrates a flowchart of a method of forming thin film passive devices integrated in a package substrate, in accordance with some embodiments, and
**Fig. 6** illustrates a smart device or a computer system or a SoC (System-on-Chip) which includes thin film passive devices integrated in a package substrate, according to some embodiments.

### DETAILED DESCRIPTION

Thin film passive devices integrated in a package substrate are generally presented. In this regard, embodiments of the present disclosure enable thin film passive devices to be formed as part of a package substrate. One skilled in the art would appreciate that these thin film passive devices may be formed using existing substrate manufacturing techniques thereby saving the expense, and surface footprint, associated with discrete components. Additionally, in some embodiments, the thin film passive devices described herein may include finer pitch features compared to discrete components and thereby enable integration of more components and enhanced features.

In the following description, numerous details are discussed to provide a more thorough explanation of embodiments of the present disclosure. It will be apparent, however, to one skilled in the art, that embodiments of the present disclosure may be practiced without these specific details. In other instances, well-known structures and devices are shown in block diagram form, rather than in detail, in order to avoid obscuring embodiments of the present disclosure.

Throughout the specification, and in the claims, the term "connected" means a direct connection, such as electrical, mechanical, or magnetic connection between the things that are connected, without any intermediary devices. The term "coupled" means a direct or indirect connection, such as a direct electrical, mechanical, or magnetic connection between the things that are connected or an indirect connection, through one or more passive or active intermediary devices. The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C). The terms "left," "right," "front," "back," "top," "bottom," "over," "under," and the like in the description and in the claims, if any, are used for descriptive purposes and not necessarily for describing permanent relative positions.

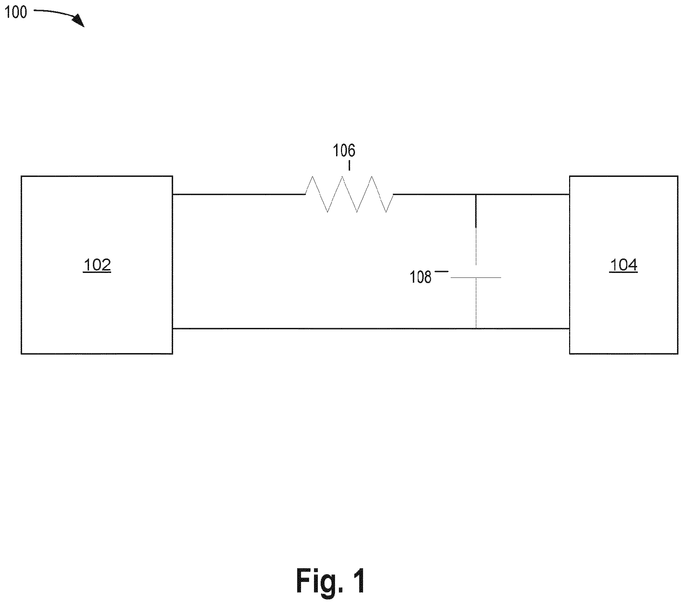

**Fig. 1** illustrates an example circuit that may be implemented with thin film passive devices integrated in a package substrate, according to some embodiments. As shown, circuit 100 includes power source 102, load 104, resistor 106, and capacitor 108. In some embodiments, circuit 100 may represent a voltage divider where load 104 may require a different voltage than provided by power source 102.

In some embodiments, power source 102 may represent a battery, voltage regulator, or other power source, that may provide an output voltage to various components within a computing system. In some embodiments, load 104 may represent a portion of an integrated circuit device, for example a core, or a controller, or other logic or circuitry. In some embodiments, load 104 is coupled with a package substrate, as described in more detail hereinafter.

Resistor 106 and capacitor 108 may form a resistor-capacitor (RC) circuit for stepping down an input voltage to an output voltage. Resistor 106 and/or capacitor 108 may include thin film resistive or insulative materials, respectively, and may be implemented as part of a package substrate, as described in more detail hereinafter. In some embodiments, resistor 106 and/or capacitor 108 may be implemented in circuits of greater or lesser complexity than circuit 100.

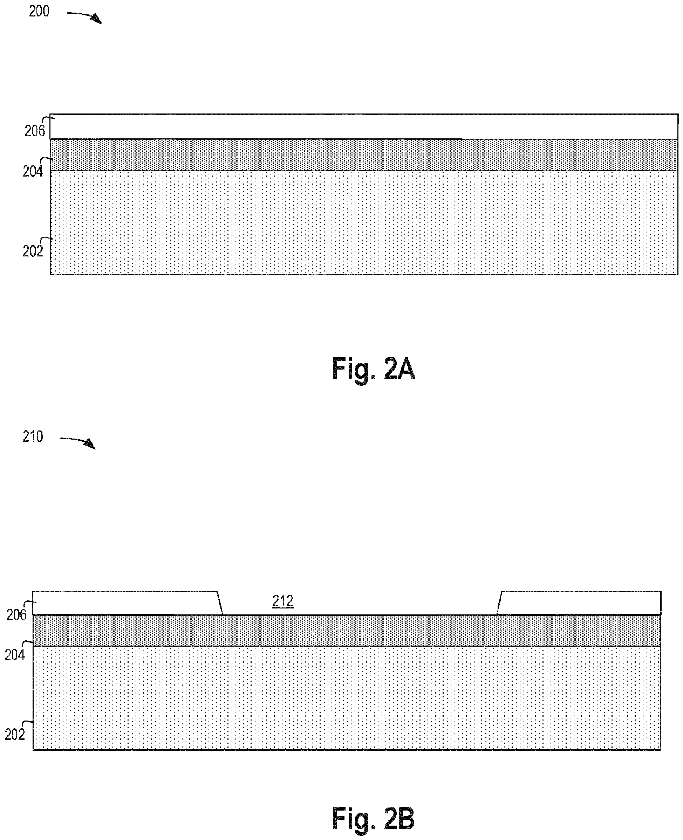

**Figs. 2A-2H** illustrate cross-sectional views of manufacturing steps of thin film passive devices integrated in a package substrate, according to some embodiments. As shown in Fig. 2A, assembly 200 includes dielectric 202, metal layer 204, and plastic film 206. In some embodiments, dielectric 202 represents a dielectric buildup film, such as an epoxy dielectric or a polymer, for example, upon which is deposited metal layer 204, which may be copper, for example. Also, assembly 200 may include additional layers not shown.

Plastic film 206 may be formed over a raw substrate for protection during transport, for example. In some embodiments, plastic film 206 may be a polyethylene terephthalate (PET) film or another plastic. Plastic film 206 may be flowed or deposited by any known techniques and may be fully or partially cured.

Fig. 2B shows assembly 210, which may include opening 212 formed in plastic film 206. In some embodiments, opening 212 is formed using a single pulse gaussian laser beam from a CO₂ laser with average power sufficient to skive plastic film 206. While opening 212 may be formed by other mechanical or chemical means, in some embodiments, a CO₂ laser operated at a wavelength of about 9400 nm is used as it would be about 90% reflective to metal layer 204, which forms the bottom of opening 212.

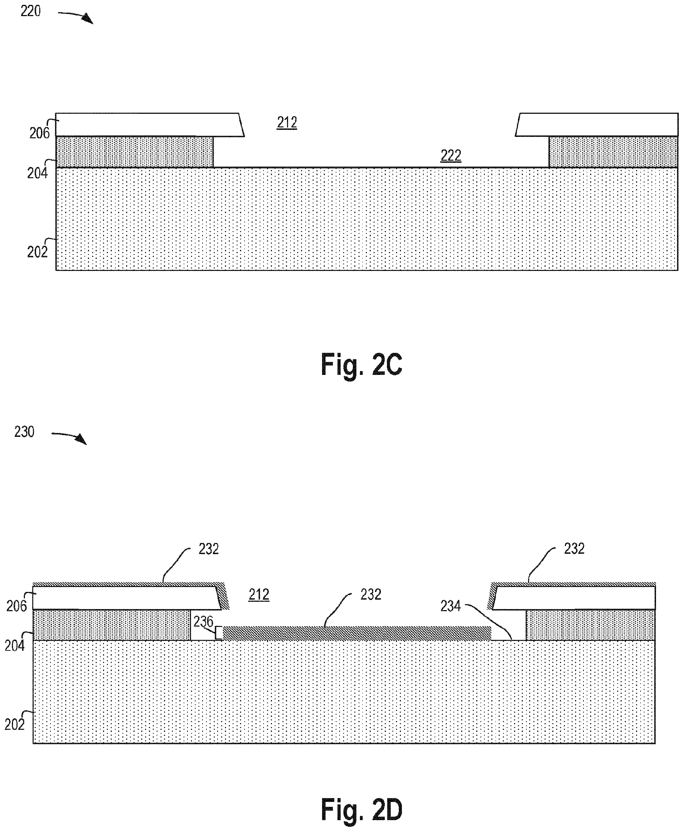

As shown in Fig. 2C, assembly 220 may have opening 222 formed in metal layer 204. In some embodiments, a subtractive chemical etch through opening 212 is used to remove portions of metal layer 204. In some embodiments, opening 222 is wider than opening 212 and opening 222 extends under portions of plastic film 206.

Turning now to Fig. 2D, assembly 230 may include thin film material 232 deposited over and through plastic film 206, including on surface 234 of dielectric 202. In some embodiments, thin film material 232 is a resistive material including, but not limited to, titanium or titanium nitride, for example. In some embodiments, thin film material 232 is deposited by sputter deposition, however other deposition or formation methods may be used. In some embodiments, thin film material 232 may have a thickness 236 of less than about 70 nm.

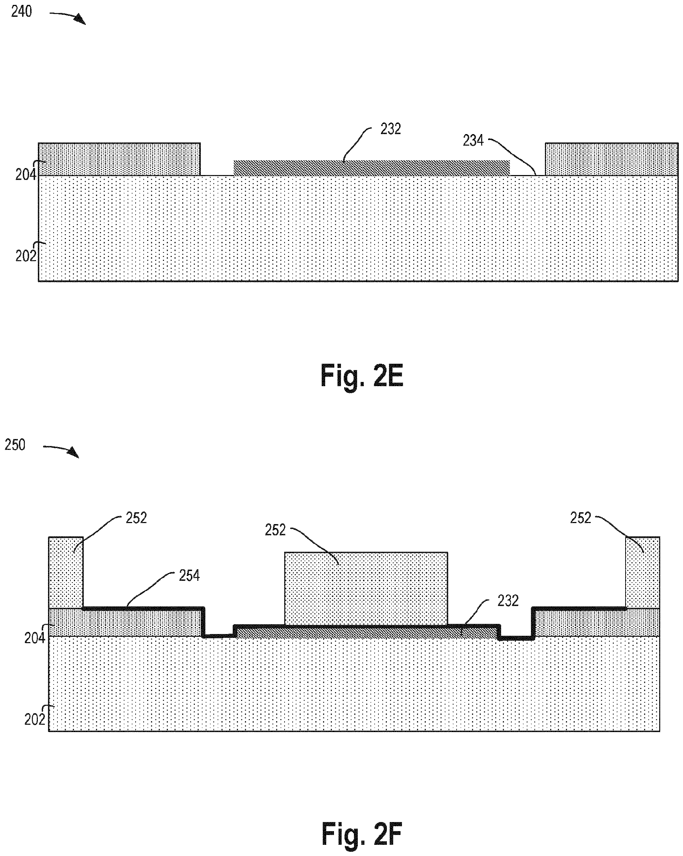

Fig. 2E shows assembly 240, which may have had plastic film 206 peeled away. In some embodiments, common mechanical and/or thermal processes are used to separate plastic film 206 from metal layer 204. One skilled in the art would appreciate that plastic film 206, which may conventionally be included to protect the substrate prior to being processed, was used as a type of hard mask for deposition of thin film material 232 on dielectric surface 234.

As shown in Fig. 2F, for assembly 250 pattern material 252 and seed layer 254 may have been deposited. In some embodiments, pattern material 252 may be photoresist material selectively formed to define the subsequent location of resistor electrodes. In some embodiments, seed layer 254 may represent copper or titanium copper alloy or some other alloy that may be deposited by electroless deposition or plating.

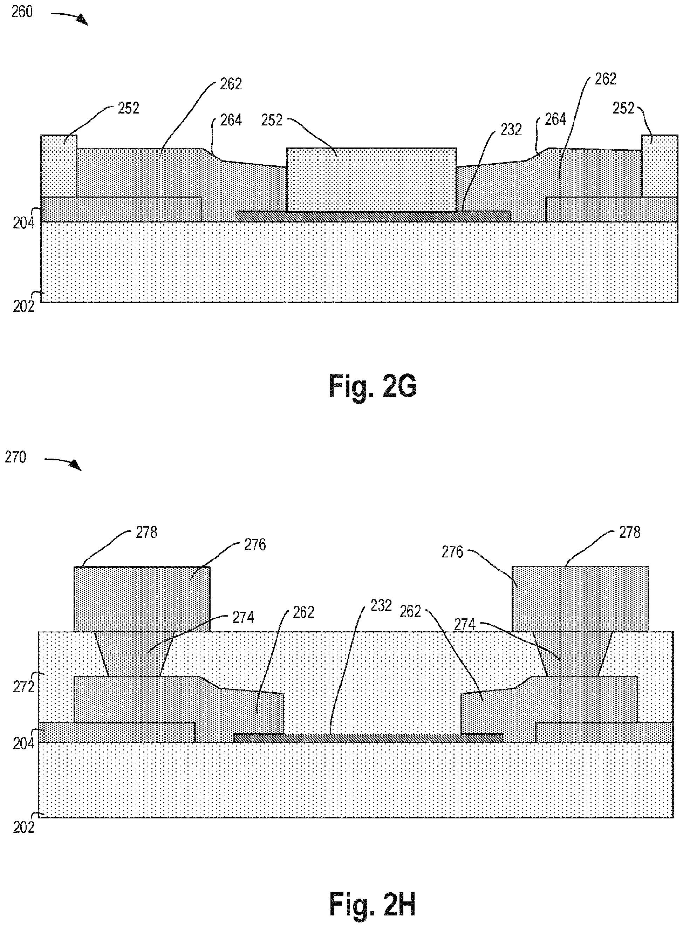

Turning now to Fig. 2G, assembly 260 may include metal plating 262 over seed layer 254. In some embodiments, metal plating 262 may be copper, copper alloy or some other metal. In some embodiments, metal plating 262 includes a sloped surface 264. In some embodiments, metal layer 204 may have a greater thickness than thin film layer 232 and electroplating of metal plating 262 may form sloped surface 264 as a result of this difference in thicknesses. In some embodiments, metal plating 262 may cover opposite ends of thin film layer 232 as well as the surface of dielectric 202 between thin film layer 232 and metal layer 204. In some embodiments, metal plating 262 may completely or partially cover metal layer 204.

Fig. 2H shows assembly 270, which may include dielectric 272, vias 274 and contacts 276. In some embodiments, dielectric 272, vias 274 and contacts 276, may be formed by standard modified semi-additive processes (MSAP) for a chip scale package (CSP). In some embodiments, contacts 276 may include principal flat surfaces 278 above dielectric 272. In some embodiments, principal flat surfaces 278 are coplanar, for example, to facilitate further processing steps In some embodiments, assembly 270 may reside on a surface of a package substrate, while in other embodiments, assembly 270 may be embedded below additional package substrate layers.

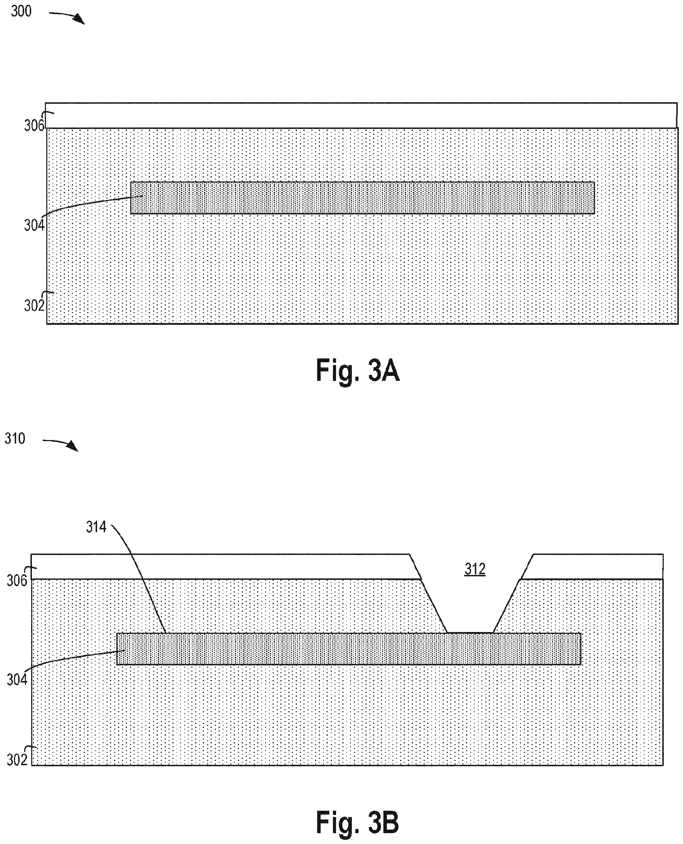

**Figs. 3A-3F** illustrate cross-sectional views of manufacturing steps of thin film passive devices integrated in a package substrate, according to some embodiments. As shown in Fig. 3A, assembly 300 includes dielectric 302, metal layer 304, and plastic film 306. In some embodiments, dielectric 302 represents a dielectric buildup film, such as an epoxy dielectric or a polymer, for example, that contains metal layer 304, which may be copper, for example. Also, assembly 300 may include additional layers not shown.

Plastic film 306 may be formed over a raw substrate for protection during transport for example. In some embodiments, plastic film 306 may be a polyethylene terephthalate (PET) film or another plastic. Plastic film 306 may be flowed or deposited by any known techniques and may be fully or partially cured.

Fig. 3B shows assembly 310, which may include opening 312 formed in plastic film 306. In some embodiments, opening 312 is formed using a single pulse gaussian laser beam from a CO₂ laser with average power sufficient to skive plastic film 306. While opening 312 may be formed by other mechanical or chemical means, in some embodiments, a CO₂ laser operated at a wavelength of about 9400 nm is used as it would also ablate dielectric 302 and be about 90% reflective to surface 314 of metal layer 304, which forms the bottom of opening 312.

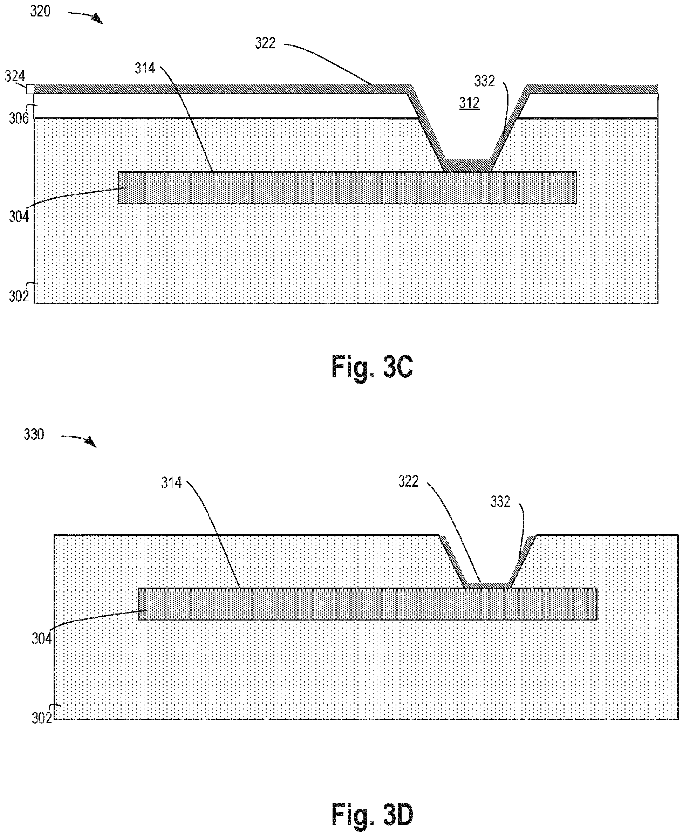

As shown in Fig. 3C, assembly 320 may have had thin film material 322 deposited over and through plastic film 306, including on sloped sidewall surface 332 of dielectric 302 and on a portion of surface 314 of metal layer 304. In some embodiments, thin film material 322 is an insulative material including, but not limited to, titanium oxide, tantalum oxide, or other ferroelectric and/or high-k material, for example. In some embodiments, thin film material 322 is deposited by sputter deposition, however other deposition or formation methods may be used. In some embodiments, thin film material 322 may have a thickness 324 of less than about 70 nm.

Turning now to Fig. 3D, assembly 330 may have had plastic film 306 peeled away. In some embodiments, common mechanical and/or thermal processes are used to separate plastic film 306 from dielectric 302. One skilled in the art would appreciate that plastic film 306, which may conventionally be included to protect the substrate prior to being processed, was used as a type of hard mask for deposition of thin film material 322.

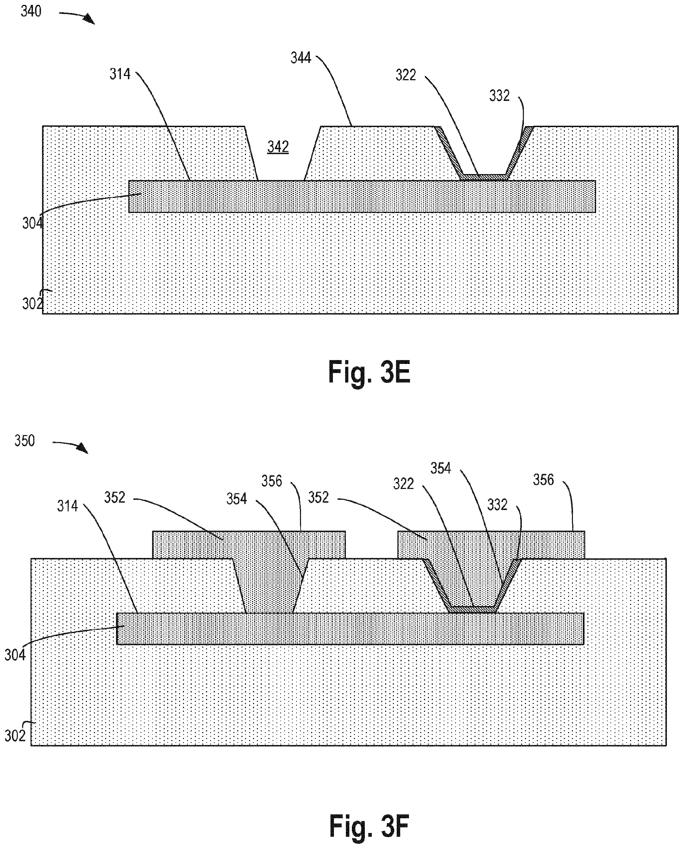

Fig. 3E shows assembly 340, which may have had opening 342 formed through surface 344 of dielectric 302. In some embodiments, a laser drilling followed by a desmear step may form opening 342. In some embodiments, dielectric surface 344 and metal layer surface 314 are parallel to each other.

As shown in Fig. 3F, for assembly 350 vias 352 may be formed that may represent capacitor electrodes. In some embodiments, vias 352 may be formed by standard modified semi-additive processes (MSAP) for a chip scale package (CSP). In some embodiments, vias 352 may include sloped surfaces 354 below a surface of dielectric 302 as well as principal flat surfaces 356 above dielectric 302. In some embodiments, principal flat surfaces 356 are coplanar, for example, to facilitate further processing steps. In some embodiments, assembly 350 may reside on a surface of a package substrate, while in other embodiments, assembly 350 may be embedded below additional package substrate layers.

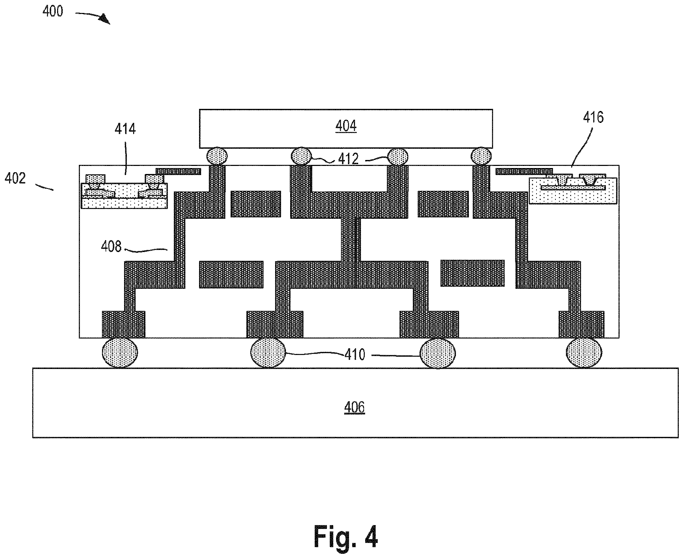

**Fig. 4** illustrates a cross-sectional view of an example system with thin film passive devices integrated in a package substrate, according to some embodiments. As shown, system 400 includes package substrate 402, integrated circuit device 404, system board 406, interconnect routing 408, solder balls 410, metal contacts 412, thin film resistor 414, and thin film capacitor 416. Integrated circuit device 404 may represent any type of device, including, but not limited to a processor, a controller, an SOC, or a transceiver. Integrated circuit device 404 may include lands (not shown) to contact with metal contacts 412.

Interconnect routing 408 may be build-up layers of metal and dielectric that couple metal contacts 412 to solder balls 410. While not shown, interconnect routing 408 would conductively couple thin film resistor 414 and thin film capacitor 416 with metal contacts 412 and/or solder balls 410. Package substrate 402 may include any number of thin film resistors 414 (such as assembly 270) and/or thin film capacitors 416 (such as assembly 350) that may be partially or completely covered by dielectric material. System board 406 may include other system components and may have solder pads (not shown) to couple with solder balls 410 of package substrate 402.

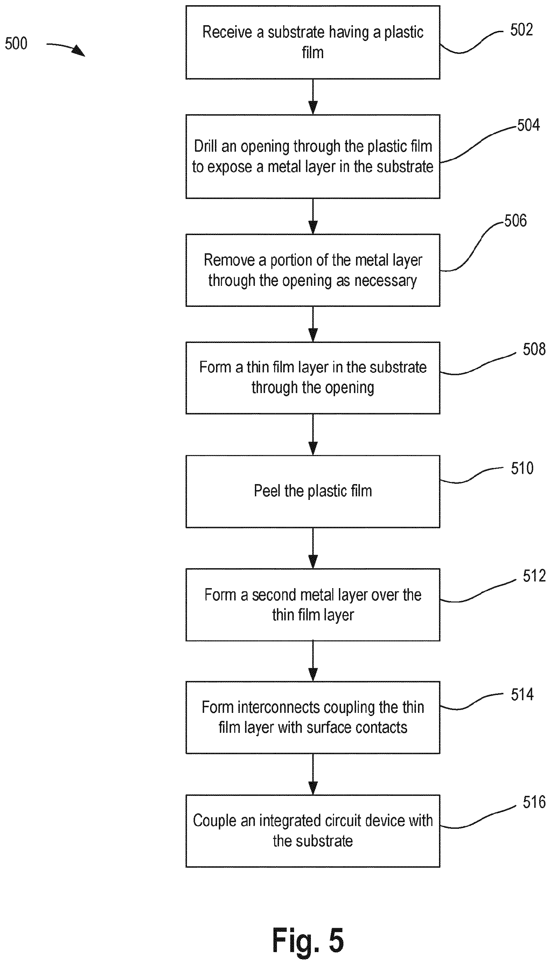

**Fig. 5** illustrates a flowchart of a method of forming thin film passive devices integrated in a package substrate, in accordance with some embodiments. Although the blocks in the flowchart with reference to **Fig. 5** are shown in a particular order, the order of the actions can be modified. Thus, the illustrated embodiments can be performed in a different order, and some actions/blocks may be performed in parallel. Some of the blocks and/or operations listed in **Fig. 5** are optional in accordance with certain embodiments. The numbering of the blocks presented is for the sake of clarity and is not intended to prescribe an order of operations in which the various blocks must occur. Additionally, operations from the various flows may be utilized in a variety of combinations.

Method 500 begins with receiving (502) a substrate having a plastic film. In some embodiments, a PET film is provided with an organic substrate to provide protection. Next, an opening is drilled (504) through the plastic film to expose a metal layer in the substrate. In some embodiments, such as assembly 210, metal layer 204 is directly below plastic film 206, while in other embodiments, such as assembly 310, metal layer 304 may be separated from plastic film 306 by dielectric 302, which may also be ablated.

Then, in some embodiments, a portion of the metal layer may be removed (506) through the opening. In some embodiments, such as assembly 220, metal layer 204 may be etched through opening 212 to expose a portion of dielectric 202. Next, a thin film layer is formed (508) in the substrate through the opening in the plastic film. In some embodiments, such as assembly 230, thin film resistive material 232 may be deposited on a planar dielectric surface 234, while in other embodiments, such as assembly 320, thin film insulative material 322 may be deposited on a planar metal surface and sloped sidewall surfaces 332 or dielectric 302.

The method continues with peeling (510) the plastic film. In some embodiments, a mechanical peel tool is used to remove plastic film 206 and 306. Next, in some embodiments, a second metal layer may be formed (512) over the thin film layer. In some embodiments, such as assembly 260, metal plating 262 is formed over opposite ends of thin film material 232, while in other embodiments, such as assembly 350, via 352 is formed completely over thin film material 322.

Next, interconnects may be formed (514) coupling the thin film layer with surface contacts. In some embodiments, resistor assembly 270 and/or capacitor assembly 350 may be embedded below a package substrate surface and routed by interconnects, such as interconnects 408, to surface contacts. In other embodiments, resistor assembly 207 and/or capacitor assembly 350 may be formed on a package substrate surface. Finally, an integrated circuit device may be coupled (516) with the substrate. In some embodiments, integrated circuit device 404 may be coupled with package substrate 402 through metal contacts 412.

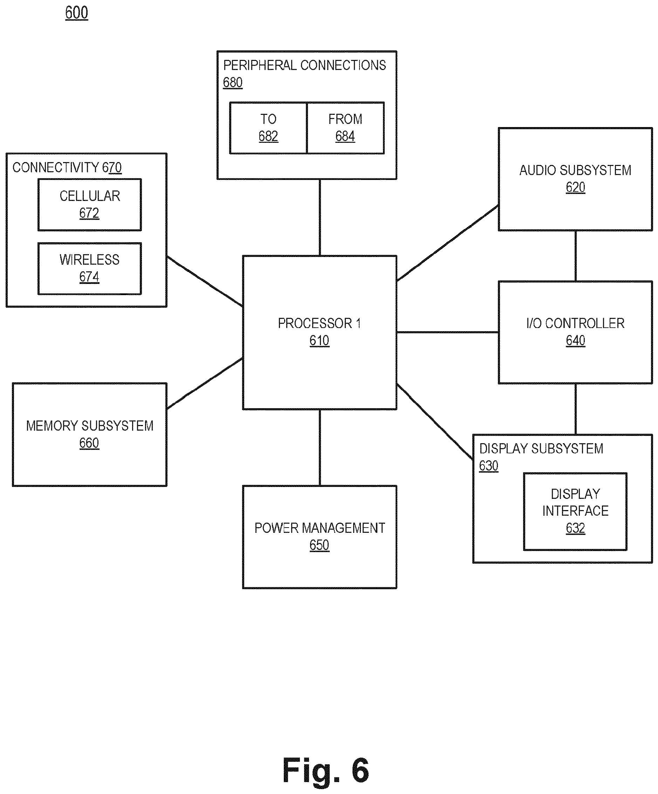

**Fig. 6** illustrates a smart device or a computer system or a SoC (System-on-Chip) which includes thin film passive devices integrated in a package substrate, according to some embodiments. In some embodiments, computing device 600 represents a mobile computing device, such as a computing tablet, a mobile phone or smart-phone, a wireless-enabled e-reader, or other wireless mobile device. It will be understood that certain components are shown generally, and not all components of such a device are shown in computing device 600. In some embodiments, one or more components of computing device 600, for example processor 610 or I/O controller 640, include thin film passive devices integrated in a package substrate as described above.

For purposes of the embodiments, the transistors in various circuits and logic blocks described here are metal oxide semiconductor (MOS) transistors or their derivatives, where the MOS transistors include drain, source, gate, and bulk terminals. The transistors and/or the MOS transistor derivatives also include Tri-Gate and FinFET transistors, Gate All Around Cylindrical Transistors, Tunneling FET (TFET), Square Wire, or Rectangular Ribbon Transistors, ferroelectric FET (FeFETs), or other devices implementing transistor functionality like carbon nanotubes or spintronic devices. MOSFET symmetrical source and drain terminals i.e., are identical terminals and are interchangeably used here. A TFET device, on the other hand, has asymmetric Source and Drain terminals. Those skilled in the art will appreciate that other transistors, for example, Bi-polar junction transistors—BJT PNP/NPN, BiCMOS, CMOS, etc., may be used without departing from the scope of the disclosure.

In some embodiments, computing device 600 includes a first processor 610. The various embodiments of the present disclosure may also comprise a network interface within 670 such as a wireless interface so that a system embodiment may be incorporated into a wireless device, for example, cell phone or personal digital assistant.

In one embodiment, processor 610 can include one or more physical devices, such as microprocessors, application processors, microcontrollers, programmable logic devices, or other processing means. The processing operations performed by processor 610 include the execution of an operating platform or operating system on which applications and/or device functions are executed. The processing operations include operations related to I/O (input/output) with a human user or with other devices, operations related to power management, and/or operations related to connecting the computing device 600 to another device. The processing operations may also include operations related to audio I/O and/or display I/O.

In one embodiment, computing device 600 includes audio subsystem 620, which represents hardware (e.g., audio hardware and audio circuits) and software (e.g., drivers, codecs) components associated with providing audio functions to the computing device. Audio functions can include speaker and/or headphone output, as well as microphone input. Devices for such functions can be integrated into computing device 600, or connected to the computing device 600. In one embodiment, a user interacts with the computing device 600 by providing audio commands that are received and processed by processor 610.

Display subsystem 630 represents hardware (e.g., display devices) and software (e.g., drivers) components that provide a visual and/or tactile display for a user to interact with the computing device 600. Display subsystem 630 includes display interface 632, which includes the particular screen or hardware device used to provide a display to a user. In one embodiment, display interface 632 includes logic separate from processor 610 to perform at least some processing related to the display. In one embodiment, display subsystem 630 includes a touch screen (or touch pad) device that provides both output and input to a user.

I/O controller 640 represents hardware devices and software components related to interaction with a user. I/O controller 640 is operable to manage hardware that is part of audio subsystem 620 and/or display subsystem 630. Additionally, I/O controller 640 illustrates a connection point for additional devices that connect to computing device 600 through which a user might interact with the system. For example, devices that can be attached to the computing device 600 might include microphone devices, speaker or stereo systems, video systems or other display devices, keyboard or keypad devices, or other I/O devices for use with specific applications such as card readers or other devices.

As mentioned above, I/O controller 640 can interact with audio subsystem 620 and/or display subsystem 630. For example, input through a microphone or other audio device can provide input or commands for one or more applications or functions of the computing device 600. Additionally, audio output can be provided instead of, or in addition to display output. In another example, if display subsystem 630 includes a touch screen, the display device also acts as an input device, which can be at least partially managed by I/O controller 640. There can also be additional buttons or switches on the computing device 600 to provide I/O functions managed by I/O controller 640.

In one embodiment, I/O controller 640 manages devices such as accelerometers, cameras, light sensors or other environmental sensors, or other hardware that can be included in the computing device 600. The input can be part of direct user interaction, as well as providing environmental input to the system to influence its operations (such as filtering for noise, adjusting displays for brightness detection, applying a flash for a camera, or other features).

In one embodiment, computing device 600 includes power management 650 that manages battery power usage, charging of the battery, and features related to power saving operation. Memory subsystem 660 includes memory devices for storing information in computing device 600. Memory can include nonvolatile (state does not change if power to the memory device is interrupted) and/or volatile (state is indeterminate if power to the memory device is interrupted) memory devices. Memory subsystem 660 can store application data, user data, music, photos, documents, or other data, as well as system data (whether long-term or temporary) related to the execution of the applications and functions of the computing device 600.

Elements of embodiments are also provided as a machine-readable medium (e.g., memory 660) for storing the computer-executable instructions. The machine-readable medium (e.g., memory 660) may include, but is not limited to, flash memory, optical disks, CD-ROMs, DVD ROMs, RAMs, EPROMs, EEPROMs, magnetic or optical cards, phase change memory (PCM), or other types of machine-readable media suitable for storing electronic or computer-executable instructions. For example, embodiments of the disclosure may be downloaded as a computer program (e.g., BIOS) which may be transferred from a remote computer (e.g., a server) to a requesting computer (e.g., a client) by way of data signals via a communication link (e.g., a modem or network connection).

Connectivity 670 includes hardware devices (e.g., wireless and/or wired connectors and communication hardware) and software components (e.g., drivers, protocol stacks) to enable the computing device 600 to communicate with external devices. The computing device 600 could be separate devices, such as other computing devices, wireless access points or base stations, as well as peripherals such as headsets, printers, or other devices.

Connectivity 670 can include multiple different types of connectivity. To generalize, the computing device 600 is illustrated with cellular connectivity 672 and wireless connectivity 674. Cellular connectivity 672 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, or other cellular service standards. Wireless connectivity (or wireless interface) 674 refers to wireless connectivity that is not cellular, and can include personal area networks (such as Bluetooth, Near Field, etc.), local area networks (such as Wi-Fi), and/or wide area networks (such as WiMax), or other wireless communication.

Peripheral connections 680 include hardware interfaces and connectors, as well as software components (e.g., drivers, protocol stacks) to make peripheral connections. It will be understood that the computing device 600 could both be a peripheral device ("to" 682) to other computing devices, as well as have peripheral devices ("from" 684) connected to it. The computing device 600 commonly has a "docking" connector to connect to other computing devices for purposes such as managing (e.g., downloading and/or uploading, changing, synchronizing) content on computing device 600. Additionally, a docking connector can allow computing device 600 to connect to certain peripherals that allow the computing device 600 to control content output, for example, to audiovisual or other systems.

In addition to a proprietary docking connector or other proprietary connection hardware, the computing device 600 can make peripheral connections 680 via common or standards-based connectors. Common types can include a Universal Serial Bus (USB) connector (which can include any of a number of different hardware interfaces), DisplayPort including MiniDisplayPort (MDP), High Definition Multimedia Interface (HDMI), Firewire, or other types.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional element.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

All optional features of the apparatus described herein may also be implemented with respect to a method or process.

In one example, a package substrate is provided comprising: one or more first conductive contacts on a first surface; one or more second conductive contacts on a second surface opposite the first surface; and a thin-film capacitor assembly comprising: a dielectric layer between the first and the second surfaces, wherein the dielectric layer contains a first metal layer; and an embedded capacitor on the dielectric layer conductively coupled with one of the first conductive contacts, wherein the embedded capacitor comprises the first metal layer on the dielectric layer, a thin film dielectric material on a surface of the metal layer, a second metal layer on the surface of the first metal layer, and a third metal layer on the thin film dielectric material, wherein the thin-film capacitor assembly resides on a surface of the package substrate, wherein the dielectric layer of the thin-film capacitor assembly is between the first and the second surfaces.

In some examples, the thin film dielectric material comprises an extension along a sloped sidewall in the dielectric layer. In some embodiments, the surface of the first metal layer is parallel with a surface of the dielectric layer. In some embodiments, the thin film dielectric material comprises a thickness of less than about 70 nm. In some embodiments, the thin film dielectric material comprises titanium oxide or tantalum oxide. In some embodiments, the second metal layer and the third metal layer comprise sloped vias and flat surfaces on opposite sides of the sloped vias. In some embodiments, the flat surfaces of the second and third metal layers are coplanar. In some embodiments, the flat surfaces of the second and third metal layers are at least partially covered by a second dielectric layer.

In another example, a system is provided comprising: a processor; a communication interface; and an integrated circuit device package, the integrated circuit device package comprising: an integrated circuit device coupled with the one or more first conductive contacts on a first substrate surface; one or more second conductive contacts of the package substrate, wherein the embedded capacitor is conductively coupled with the integrated circuit device.

In some examples, the thin film dielectric material comprises an extension along a sloped sidewall in the dielectric layer. In some embodiments, the surface of the first metal layer is parallel with a surface of the dielectric layer. In some embodiments, the thin film dielectric material comprises a thickness of less than about 70 nm. In some embodiments, the thin film dielectric material comprises titanium oxide or tantalum oxide. In some embodiments, the second metal layer and the third metal layer comprise sloped vias and flat surfaces on opposite sides of the sloped vias. In some embodiments, the flat surfaces of the second and third metal layers are coplanar. In some embodiments, the flat surfaces of the second and third metal layers are at least partially covered by a second dielectric layer.

In another example, a method of manufacturing a package substrate comprising: forming a thin-film capacitor assembly, comprising drilling an opening through a plastic film formed over a dielectric layer, wherein the dielectric layer contains a first metal layer, wherein drilling the opening exposes a first metal layer in the substrate dielectric layer; forming an embedded capacitor on the dielectric layer, the embedded capacitor comprising the first metal layer on the dielectric layer, a thin film dielectric material, a second metal layer, and a third metal layer, forming the thin film dielectric material on a surface of the first metal layer; peeling the plastic film from the substrate; forming the second metal layer on a surface of the first metal layer; and forming a third metal layer in contact with on the thin film layerdielectric material, wherein the thin-film capacitor assembly resides on a surface of a package substrate, wherein the package substrate comprises one or more first conductive contacts on a first surface, and one or more second conductive contacts on a second surface, wherein the second surface is opposite the first surface, wherein the dielectric layer resides between the first and the second surfaces, and wherein the embedded capacitor is conductively coupled with one of the first conductive contacts.

In some examples, drilling an opening through the plastic film comprises skiving an opening with a CO₂ laser through a polyethylene terephthalate (PET) film. In some embodiments, the thin film layer comprises a thin film dielectric material. In some embodiments, forming the thin film dielectric material comprises forming the thin film dielectric material on a surface of the first metal layer and a surface of a dielectric layer over the first metal layer formed by drilling the opening. Some embodiments also include forming a metal via in contact with the first metal layer. In some embodiments, the thin film layer comprises a thin film resistive material. In some embodiments, forming the thin film resistive material comprises removing a portion of the first metal layer and forming the thin film resistive material on a surface of a dielectric layer under the first metal layer. In some embodiments, removing a portion of the first metal layer comprises selective etching a width of the first metal layer greater than a width of the opening in the plastic film.

In another example, a package substrate is provided comprising: one or more first conductive contacts on a first surface; one or more second conductive contacts on a second surface opposite the first surface; a dielectric layer between the first and the second surfaces; a thin-film capacitor assembly and an embedded resistor on the dielectric layer conductively coupled with one of the first conductive contacts, wherein the embedded resistor comprises a thin film resistive material on a surface of the dielectric layer, a first and a second metal layers on the surface of the dielectric layer, a third metal layer on the first metal layer, and a forth metal layer on the second metal layer, wherein the third and the forth metal layers are on opposite ends of the thin film resistive material, wherein the thin-film capacitor assembly comprises a dielectric layer, wherein the dielectric layer contains a first metal layer; an embedded capacitor on the dielectric layer conductively coupled with one of the first conductive contacts, wherein the embedded capacitor comprises the first metal layer on the dielectric layer, a thin film dielectric material on a surface of the first metal layer, a second metal layer on the surface of the first metal layer, and a third metal layer on the thin film dielectric material, wherein the thin-film capacitor assembly resides on a surface of the package substrate, wherein the dielectric layer of the thin-film capacitor assembly is between the first and the second surfaces.

In some examples, the third metal layer and the fourth metal layer comprise sloped surfaces on sides opposite to the thin film resistive material. In some examples, the third metal layer covers the first metal layer and the surface of the dielectric layer between the first metal layer and the thin film resistive material and wherein the fourth metal layer covers the second metal layer and the surface of the dielectric layer between the second metal layer and the thin film resistive material. In some examples, the thin film resistive material comprises a thickness of less than about 70 nm. In some examples, the thin film resistive material comprises titanium. In some examples, the third metal layer and the fourth metal layer comprise flat surfaces adjacent the sloped surfaces. In some examples, the flat surfaces of the third and fourth metal layers are coplanar. In some examples, the flat surfaces of the third and fourth metal layers are at least partially covered by a second dielectric layer.

In another example, a system is provided comprising: a processor; a communication interface; and an integrated circuit device package, the integrated circuit device package comprising: an integrated circuit device coupled with one or more first conductive contacts on a first substrate surface; one or more second conductive contacts on a second substrate surface opposite the first substrate surface; a dielectric layer between the first and the second substrate surfaces; a thin-film capacitor assembly and an embedded resistor on the dielectric layer conductively coupled with the integrated circuit device, wherein the embedded resistor comprises a thin film resistive material on a surface of the dielectric layer, a first and a second metal layers on the surface of the dielectric layer, a third metal layer on the first metal layer, and a forth metal layer on the second metal layer, wherein the third and the forth metal layers are on opposite ends of the thin film resistive material, wherein the thin-film capacitor assembly comprises a dielectric layer, wherein the dielectric layer contains a first metal layer; an embedded capacitor on the dielectric layer conductively coupled with one of the first conductive contacts, wherein the embedded capacitor comprises the first metal layer on the dielectric layer, a thin film dielectric material on a surface of the first metal layer, a second metal layer on the surface of the first metal layer, and a third metal layer on the thin film dielectric material, wherein the thin-film capacitor assembly resides on a surface of the package substrate, wherein the dielectric layer of the thin-film capacitor assembly is between the first and the second surfaces.

In some examples, the third metal layer and the fourth metal layer comprise sloped surfaces on sides opposite to the thin film resistive material. In some examples, the third metal layer covers the first metal layer and the surface of the dielectric layer between the first metal layer and the thin film resistive material and wherein the fourth metal layer covers the second metal layer and the surface of the dielectric layer between the second metal layer and the thin film resistive material. In some examples, the thin film resistive material comprises a thickness of less than about 70 nm. In some examples, the thin film resistive material comprises titanium. In some examples, the third metal layer and the fourth metal layer comprise flat surfaces adjacent the sloped surfaces. In some examples, the flat surfaces of the third and fourth metal layers are coplanar. In some examples, the flat surfaces of the third and fourth metal layers are at least partially covered by a second dielectric layer.

## Claims

1. A package substrate (402) comprising:
one or more first conductive contacts (412) on a first surface;
one or more second conductive contacts (410) on a second surface opposite the first surface; and
a thin-film capacitor assembly (350) comprising:
a dielectric layer (302), wherein the dielectric layer (302) contains a first metal layer (304);
an embedded capacitor (416) on the dielectric layer (302) conductively coupled with one of the first conductive contacts (412), wherein the embedded capacitor comprises the first metal layer (304) on the dielectric layer (302), a thin film dielectric material (322) on a surface of the first metal layer (304), a second metal layer (352) on the surface of the first metal layer (304), and
a third metal layer (352) on the thin film dielectric material (322),
wherein the thin-film capacitor assembly (350) resides on a surface of the package substrate, wherein the dielectric layer (302) of the thin-film capacitor assembly is between the first and the second surfaces.

2. The package substrate of claim 1, wherein the thin film dielectric material (322) comprises an extension along a sloped sidewall (332) in the dielectric layer (302).

3. The package substrate of claim 2, wherein the surface of the first metal layer (304) is parallel with a surface of the dielectric layer.

4. The package substrate of claim 2, wherein the thin film dielectric material (322) comprises a thickness of less than about 70 nm.

5. The package substrate of claim 2, wherein the thin film dielectric material (322) comprises titanium oxide or tantalum oxide.

6. A system (600, 400) comprising:
a processor (610);
a communication interface (670); and
an integrated circuit device package (400), the integrated circuit device package comprising:
an integrated circuit device (404) coupled with the one or more first conductive contacts (412) of the package substrate (402) of any of claims 1 to 5, wherein the;
embedded capacitor (416) is conductively coupled with the integrated circuit device.

7. A method (500) of manufacturing a package substrate, the method comprising:
forming a thin-film capacitor assembly, comprising
drilling (504) an opening through a plastic film formed over a dielectric layer, wherein the dielectric layer contains a first metal layer, wherein drilling the opening exposes the first metal layer in the dielectric layer;
forming an embedded capacitor on the dielectric layer, the embedded capacitor comprising the first metal layer on the dielectric layer, a thin film dielectric material, a second metal layer, and a third metal layer,
forming (508) the thin film dielectric material on a surface of the first metal layer; peeling (510) the plastic film from the substrate; forming (512) the second metal layer on a surface of the first metal layer; and
forming a third metal layer on the thin film dielectric material,
wherein the thin-film capacitor assembly resides on a surface of a package substrate, wherein the package substrate comprises one or more first conductive contacts on a first surface, and one or more second conductive contacts on a second surface, wherein the second surface is opposite the first surface,
wherein the dielectric layer resides between the first and the second surfaces, and wherein the embedded capacitor is conductively coupled with one of the first conductive contacts.

8. The method of claim 7, wherein the plastic film is a polyethylene terephthalate (PET) film, and wherein drilling an opening through the plastic film comprises skiving an opening with a CO₂ laser through the polyethylene terephthalate (PET) film.

9. The method of claim 7, wherein forming the thin film dielectric material comprises forming the thin film dielectric material on a surface of the first metal layer and a surface of a dielectric layer over the first metal layer formed by drilling the opening.

10. An apparatus produced from the method of any of claims 7 to 9.

## Patentansprüche

1. Gehäusesubstrat (402), das Folgendes umfasst:
einen oder mehrere leitfähige Kontakte (412) auf einer ersten Oberfläche;
einen oder mehrere zweite leitfähige Kontakte (410) auf einer zweiten Oberfläche gegenüber der ersten Oberfläche; und
eine Dünnfilmkondensatorbaugruppe (350), die Folgendes umfasst:
eine dielektrische Schicht (302), wobei die dielektrische Schicht (302) eine erste Metallschicht (304) enthält;
einen eingebetteten Kondensator (416) auf der dielektrischen Schicht (302), der leitfähig mit einem der ersten leitfähigen Kontakte (412) gekoppelt ist, wobei der eingebettete Kondensator die erste Metallschicht (304) auf der dielektrischen Schicht (302), ein dielektrisches Dünnfilmmaterial (322) auf einer Oberfläche der ersten Metallschicht (304), eine zweite Metallschicht (352) auf der Oberfläche der ersten Metallschicht (304) und eine dritte Metallschicht (352) auf dem dielektrischen Dünnfilmmaterial (322) umfasst,
wobei sich die Dünnfilmkondensatorgruppe (350) auf einer Oberfläche des Gehäusesubstrats befindet, wobei sich die dielektrische Schicht (302) der Dünnfilmkondensatorbaugruppe zwischen der ersten und zweiten Oberfläche befindet.

2. Gehäusesubstrat nach Anspruch 1, wobei das dielektrische Dünnfilmmaterial (322) eine Erweiterung entlang einer geneigten Seitenwand (332) in der dielektrischen Schicht (302) umfasst.

3. Gehäusesubstrat nach Anspruch 2, wobei die Oberfläche der ersten Metallschicht (304) parallel zu einer Oberfläche der dielektrischen Schicht ist.

4. Gehäusesubstrat nach Anspruch 2, wobei das dielektrische Dünnfilmmaterial (322) eine Dicke von weniger als etwa 70 nm umfasst.

5. Gehäusesubstrat nach Anspruch 2, wobei das dielektrische Dünnfilmmaterial (322) Titanoxid oder Tantaloxid umfasst.

6. System (600, 400), das Folgendes umfasst:
einen Prozessor (610);
eine Kommunikationsschnittstelle (670); und
ein Integrierter-Schaltkreis-Vorrichtungsgehäuse (400), wobei das Integrierter-Schaltkreis-Vorrichtungsgehäuse Folgendes umfasst:
eine Integrierter-Schaltkreis-Vorrichtung (404), die mit dem einem oder den mehreren ersten leitfähigen Kontakten (412) des Gehäusesubstrats (402) nach einem der Ansprüche 1 bis 5 gekoppelt ist, wobei
der eingebettete Kondensator (416) leitfähig mit der Integrierter-Schaltkreis-Vorrichtung gekoppelt ist.

7. Verfahren (500) zum Herstellen eines Gehäusesubstrats, wobei das Verfahren Folgendes umfasst:
Bilden einer Dünnfilmkondensatorbaugruppe, umfassend:
Bohren (504) einer Öffnung durch einen Kunststofffilm, der über einer dielektrischen Schicht gebildet ist, wobei die dielektrische Schicht eine erste Metallschicht enthält, wobei das Bohren der Öffnung die erste Metallschicht in der dielektrischen Schicht freilegt;
Bilden eines eingebetteten Kondensators auf der dielektrischen Schicht, wobei der eingebettete Kondensator die erste Metallschicht auf der dielektrischen Schicht, ein dielektrisches Dünnfilmmaterial, eine zweite Metallschicht und eine dritte Metallschicht umfasst,
Bilden (508) des dielektrischen Dünnfilmmaterials auf einer Oberfläche der ersten Metallschicht; Ablösen (510) des Kunststofffilms von dem Substrat; Bilden (512) der zweiten Metallschicht auf einer Oberfläche der ersten Metallschicht; und
Bilden einer dritten Metallschicht auf dem dielektrischen Dünnfilmmaterial,
wobei sich die Dünnfilmkondensatorbaugruppe auf einer Oberfläche eines Gehäusesubstrats befindet, wobei das Gehäusesubstrat einen oder mehrere leitfähige Kontakte auf einer ersten Oberfläche und ein oder mehrere zweite leitfähige Kontakte auf einer zweiten Oberfläche umfasst, wobei die zweite Oberfläche der ersten Oberfläche gegenüberliegt,
wobei sich die dielektrische Schicht zwischen der ersten und der zweiten Oberfläche befindet und wobei der eingebettete Kondensator leitfähig mit einem der ersten leitfähigen Kontakte gekoppelt ist.

8. Verfahren nach Anspruch 7, wobei der Kunststofffilm ein Polyethylenterephthalat(PET)-Film ist, und wobei das Bohren einer Öffnung durch den Kunststoffilm Abschälen einer Öffnung mit einem CO₂-Laser durch den Polyethylenterephthalat(PET)-Film umfasst.

9. Verfahren nach Anspruch 7, wobei das Bilden des dielektrischen Dünnfilmmaterials Bilden des dielektrischen Dünnfilmmaterials auf einer Oberfläche der ersten Metallschicht und einer Oberfläche einer dielektrischen Schicht über der ersten Metallschicht umfasst, die durch Bohren der Öffnung gebildet wird.

10. Einrichtung, die durch das Verfahren nach einem der Ansprüche 7 bis 9 produziert wird.

## Revendications

1. Substrat de boîtier (402) comprenant :
un ou plusieurs premiers contacts conducteurs (412) sur une première surface ;
un ou plusieurs deuxièmes contacts conducteurs (410) sur une deuxième surface à l'opposé de la première surface ; et
un ensemble condensateur en couche mince (350) comprenant :
une couche diélectrique (302), la couche diélectrique (302) contenant une première couche métallique (304) ;
un condensateur intégré (416) sur la couche diélectrique (302) couplé de façon conductrice à un des premiers contacts conducteurs (412), le condensateur intégré comprenant la première couche métallique (304) sur la couche diélectrique (302), un matériau diélectrique en couche mince (322) sur une surface de la première couche métallique (304), une deuxième couche métallique (352) sur la surface de la première couche métallique (304), et une troisième couche métallique (352) sur le matériau diélectrique en couche mince (322),
l'ensemble condensateur en couche mince (350) se trouvant sur une surface du substrat de boîtier, la couche diélectrique (302) de l'ensemble condensateur en couche mince se situant entre la première et la deuxième surface.

2. Substrat de boîtier de la revendication 1, dans lequel le matériau diélectrique en couche mince (322) comprend un prolongement le long d'une paroi latérale inclinée (332) dans la couche diélectrique (302).

3. Substrat de boîtier de la revendication 2, dans lequel la surface de la première couche métallique (304) est parallèle à une surface de la couche diélectrique.

4. Substrat de boîtier de la revendication 2, dans lequel le matériau diélectrique en couche mince (322) présente une épaisseur inférieure à environ 70 nm.

5. Substrat de boîtier de la revendication 2, dans lequel le matériau diélectrique en couche mince (322) comprend de l'oxyde de titane ou de l'oxyde de tantale.

6. Système (600, 400) comprenant :
un processeur (610) ;
une interface de communication (670) ; et
un boîtier de dispositif à circuit intégré (400), le boîtier de dispositif à circuit intégré comprenant :
un dispositif à circuit intégré (404) couplé au(x) premier(s) contact(s) conducteur(s) (412) du substrat de boîtier (402) de l'une quelconque des revendications 1 à 5,
le condensateur intégré (416) étant couplé de façon conductrice au dispositif à circuit intégré.

7. Procédé (500) de fabrication d'un substrat de boîtier, le procédé comprenant :
la formation d'un ensemble condensateur en couche mince, comprenant
le perçage (504) d'une ouverture à travers un film de plastique formé par-dessus une couche diélectrique, la couche diélectrique contenant une première couche métallique, le perçage de l'ouverture exposant la première couche métallique dans la couche diélectrique ;
la formation d'un condensateur intégré sur la couche diélectrique, le condensateur intégré comprenant la première couche métallique sur la couche diélectrique, un matériau diélectrique en couche mince, une deuxième couche métallique, et une troisième couche métallique ;
la formation (508) du matériau diélectrique en couche mince sur une surface de la première couche métallique ; le décollement (510) du film de plastique du substrat ; la formation (512) de la deuxième couche métallique sur une surface de la première couche métallique ; et
la formation d'une troisième couche métallique sur le matériau diélectrique en couche mince,
dans lequel l'ensemble condensateur en couche mince se trouve sur une surface d'un substrat de boîtier, le substrat de boîtier comprenant un ou plusieurs premiers contacts conducteurs sur une première surface, et un ou plusieurs deuxièmes contacts conducteurs sur une deuxième surface, la deuxième surface étant à l'opposé de la première surface,
dans lequel la couche diélectrique se trouve entre la première et la deuxième surface, et dans lequel le condensateur intégré est couplé de façon conductrice à un des premiers contacts conducteurs.

8. Procédé de la revendication 7, dans lequel le film de plastique est un film de téréphtalate de polyéthylène (PET), et dans lequel le perçage d'une ouverture à travers le film de plastique comprend le parage d'une ouverture avec un laser à CO₂ à travers le film de téréphtalate de polyéthylène (PET).

9. Procédé de la revendication 7, dans lequel la formation du matériau diélectrique en couche mince comprend la formation du matériau diélectrique en couche mince sur une surface de la première couche métallique et une surface d'une couche diélectrique par-dessus la première couche métallique formée par perçage de l'ouverture.

10. Appareil produit par le procédé de l'une quelconque des revendications 7 à 9.
